# EUROPEAN PATENT APPLICATION

(11) **EP 2 845 922 A1**
(43) Date of publication of application: **11.03.2015**
(21) Application number: 14183347.5
(22) Date of filing: 03.09.2014
(51) Int. Cl.: C23C 18/18, C23C 18/20, B01J 31/02, C23C 18/30, H05K 3/42

(54) **Electroless metallization of dielectrics with alkaline stable pyrimidine derivative containing catalysts**

(30) Priority: 04.09.2013 US 201361873389 P
(71) Applicant: Rohm and Haas Electronic Materials LLC, Marlborough, MA 01752 (US)
(72) Inventor: Milum, Kristen M., Boylston, MA Massachusetts 01505 (US); Rzeznik, Maria Anna, Shrewsbury, MA Massachusetts 01545 (US); Cleary, Donald E., Litteton, MA Massachusetts 01460 (US); Kozhukh, Julia, Cambridge, MA Massachusetts 02139 (US); Niazimbetova, Zuhra I., Westborough, MA Massachusetts 01581 (US)
(74) Representative: Houghton, Mark Phillip

(57) **Abstract**

Pyrimidine derivatives which contain one or more electron donating groups on the ring are used as catalytic metal complexing agents in aqueous alkaline environments to catalyze electroless metal plating on metal clad and un-clad substrates. The catalysts are monomers and free of tin and antioxidants.

## Description

### Field of the Invention

The present invention is directed to electroless metallization of dielectrics with alkaline stable monomeric pyrimidine derivative containing catalysts. More specifically, the present invention is directed to metallization of dielectrics with alkaline stable monomeric pyrimidine derivative containing catalysts as a replacement for palladium/tin colloidal catalysts.

### Background of the Invention

Conventional printed circuit boards (PCBs) consist of laminated non-conductive dielectric substrates that rely on drilled and plated through holes (PTHs) to form a connection between the opposite sides and/or inner layers of a board. Electroless plating is a well-known process for preparing metallic coatings on surfaces. Electroless plating of a dielectric surface requires the prior deposition of a catalyst. The most commonly used method to catalyze or activate laminated non-conductive dielectric substrate regions, prior to electroless plating, is to treat the board with an aqueous tin-palladium colloid in an acidic chloride medium. The colloid consists of a metallic palladium core surrounded by a stabilizing layer of tin(II) ions. A shell of [SnCl₃]⁻ complexes act as surface stabilizing groups to avoid agglomeration of colloids in suspension.

In the activation process, the palladium-based colloid is adsorbed onto an insulating substrate such as epoxy or polyimide to activate electroless copper deposition. Theoretically, for electroless metal deposition, the catalyst particles play roles as carriers in the path of transfer of electrons from reducing agent to metal ions in the plating bath. Although the performance of an electroless copper process is influenced by many factors such as composition of the deposition solution and choice of ligand, the activation step is the key factor for controlling the rate and mechanism of electroless deposition. Palladium/tin colloid has been commercially used as an activator for electroless metal deposition for decades, and its structure has been extensively studied. Yet, its sensitivity to air and high cost leave room for improvement or substitution.

While the colloidal palladium catalyst has given good service, it has many shortcomings which are becoming more and more pronounced as the quality of manufactured printed circuit boards increases. In recent years, along with the reduction in sizes and an increase in performance of electronic devices, the packaging density of electronic circuits has become higher and subsequently required to be defect free after electroless plating. As a result of greater demands on reliability alternative catalyst compositions are required. The stability of the colloidal palladium catalyst is also a concern. As mentioned above, the palladium/tin colloid is stabilized by a layer of tin(II) ions and its counter-ions can prevent palladium from aggregating. The tin(II) ions easily oxidizes to tin(IV) and thus the colloid cannot maintain its colloidal structure. This oxidation is promoted by increases in temperature and agitation. If the tin(II) concentration is allowed to fall close to zero, then palladium particles can grow in size, agglomerate, and precipitate.

Considerable efforts have been made to find new and better catalysts. For example, because of the high cost of palladium, much of the effort has been directed toward the development of a non-palladium or bimetallic alternative catalysts. In the past, problems have included the fact that they are not sufficiently active or reliable enough for through-hole plating. Furthermore, these catalysts typically become progressively less active upon standing, and this change in activity renders such catalysts unreliable and impractical for commercial use. U.S. 4,248,632 discloses a non-palladium/tin catalyst for electroless plating. The catalyst includes a complex of a catalytic metal, such as palladium or alternative metals such as silver and gold, nitrogen containing ligands and acid radicals; however, an acid environment is critical for its activating performance. Acid environments typically cause undesired corrosion of metal cladding found on many dielectric substrates resulting in defective articles. This problem is very common in the manufacture of printed circuit boards where the boards are often heavily clad with copper, thus acid environments are highly undesirable in the industry.

Preferably metal clad dielectrics are electrolessly plated in alkaline environments but many non-palladium/tin catalysts are unstable and unreliable under such conditions. U.S. 5,503,877 discloses another non-palladium/tin catalyst which may be used in an acid as well as an alkaline environment. The catalyst is composed of a catalytic metal such as palladium, silver or gold, nitrogen containing ligands and solvent component; however, the catalyst must first be heated for prolonged periods of time prior to use to form an oligomer/polymer otherwise it is insufficiently active. Further, prolonged heating and subsequent cooling causes more cost due to increased manpower and facility charges in large scale catalyst preparation. Accordingly, there is still a need for a replacement catalyst for palladium/tin.

### Summary of the Invention

Methods include providing a substrate including a dielectric; applying an aqueous alkaline catalyst solution to the substrate including the dielectric, the aqueous alkaline catalyst includes a monomeric complex of metal ions and one or more pyrimidine derivatives having formula: 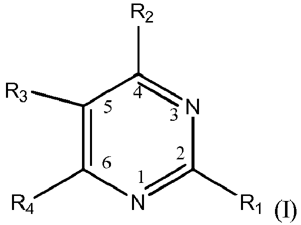 where R₁, R₂, R₃ and R₄ may be the same or different and are hydrogen, (C₁-C₃)alky,-N(R)₂, hydroxyl, hydroxy(C₁-C₃)alkyl, (C₁-C₃)alkoxy, carboxy or halogen, and where R may be the same or different and is hydrogen or (C₁-C₃)alkyl, and with the proviso that when R₂ and R₄ are hydroxyl, R₁ is also hydroxyl, R₁, R₂ and R₄ cannot be -N(R)₂ at the same instance and when R₂ is an alkyl, R₁, R₃ and R₄ cannot all be hydrogen, and R₁, R₂, R₃ and R₄ are not hydrogen at the same instance; or salts thereof; applying a reducing agent to the substrate including the dielectric; and immersing the substrate including the dielectric into an alkaline metal plating bath to electrolessly plate metal on the substrate with the dielectric.

The aqueous alkaline catalysts may be used to electrolessly plate metals on substrates of dielectric materials and substrates which also include metal cladding. The aqueous alkaline catalysts are storage stable and are stable during electroless metal plating even in alkaline electroless metal plating environments. They do not readily oxidize as compared to conventional tin/palladium catalysts even though the aqueous alkaline catalysts are free of antioxidants. They do not require strong acids to prepare or maintain stability, thus they are less corrosive than conventional catalysts. They do not require tin compounds for stability and may be halogen free. Also, oligomeric/polymeric complex formation with prolonged heating is not required to form stable and catalytically active metal ligand complexes, thus providing a more efficient electroless plating method. The catalysts enable good metal coverage during via and through-hole filling in the manufacture of printed circuit boards.

### Brief Description of the Drawings

Figure 1 is a plot of the backlight performance of a palladium/6-hydroxy-2,4-dimethylpyrimidine catalyst vs. a conventional tin/palladium colloidal catalyst on through-hole walls of multiple substrates.
Figure 2 is a plot of the backlight performance of a palladium/2-amino-4,6-dimethylpyrimidine catalyst vs. a conventional tin/palladium catalyst on through-hole walls of multiple substrates.

### Detailed Description of the Invention

As used throughout this specification, the abbreviations given below have the following meanings, unless the context clearly indicates otherwise: g = gram; mg = milligram; mL = milliliter; L = liter; cm = centimeter; m = meter; mm = millimeter; µm = micron; ppm = parts per million; M = molar; ° C = degrees Centigrade; g/L = grams per liter; DI = deionized; Pd = palladium; wt% = percent by weight; and T_{g} = glass transition temperature.

The term "monomer" or "monomeric" means a single molecule which may combine with one or more of the same or similar molecules. The term "oligomer" means two or three monomers combined to form a single molecule. The term "polymer" means two or more monomers combined or two or more oligomers combined to form a single molecule. The term "halogen" means chlorine, bromine, fluorine and iodine. The terms "printed circuit board" and "printed wiring board" are used interchangeably throughout this specification. The terms "plating" and "deposition" are used interchangeably throughout this specification. All amounts are percent by weight, unless otherwise noted. All numerical ranges are inclusive and combinable in any order except where it is logical that such numerical ranges are constrained to add up to 100%.

Aqueous akaline catalyst solutions include complexes of metal ions chosen from silver, gold, platinum, palladium, copper, cobalt and nickel, and one or more pyrimidine derivative complexing compounds having formula: 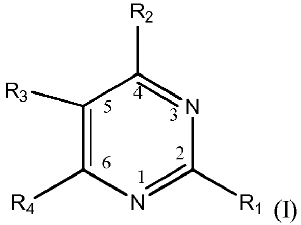 where R₁, R₂, R₃ and R₄ may be the same or different and are hydrogen, (C₁-C₃)alky,-N(R)₂, hydroxyl, hydroxy(C₁-C₃)alkyl, (C₁-C₃)alkoxy, carboxy or halogen, and where R may be the same or different and is hydrogen or (C₁-C₃)alkyl, and with the proviso that when R₂ and R₄ are hydroxyl, R₁ is also hydroxyl, R₁, R₂ and R₄ cannot be -N(R)₂ at the same instance and when R₂ is an alkyl, R₁, R₃ and R₄ cannot all be hydrogen, and R₁, R₂, R₃ and R₄ are not all hydrogen at the same instance; or salts thereof Preferably R₁, R₂, R₃ and R₄ are independently hydrogen, (C₁-C₂)alkyl, -N(R)₂ where R may be the same or different and is hydrogen or (C₁-C₂)alkyl; hydroxyl, (C₁-C₂)alkoxy, carboxy or chlorine with the proviso that when R₂ and R₄ are hydroxyl, R₁ is also hydroxyl, R₁, R₃ and R₄ cannot be -N(R)₂ at the same instance and when R₂ is an alkyl, R₁, R₃ and R₄ cannot all be hydrogen, and R₁, R₂, R₃ and R₄ are not hydrogen at the same instance. More preferably, R₁, R₂, R₃ and R₄ are independently hydrogen, methyl, -NH₂, hydroxyl, methoxy, carboxy or chlorine with the proviso that when R₂ and R₄ are hydroxyl, R₁ is also hydroxyl, R₁, R₃ and R₄ cannot be -NH₂ at the same instance and when R₂ is methyl, R₁, R₃ and R₄ cannot all be hydrogen, and R₁, R₂, R₃ and R₄ are not hydrogen at the same instance. Most preferably, R₁, R₂, R₃ and R₄ are independently hydrogen, methyl, -NH₂, or hydroxyl, with the proviso that when R₂ and R₄ are hydroxyl, R₁ is also hydroxyl, R₁, R₃ and R₄ cannot be -NH₂ at the same instance and when R₂ is methyl, R₁, R₃ and R₄ cannot all be hydrogen, and R₁, R₂, R₃ and R₄ are not hydrogen at the same instance. In general such pyrimidine derivatives are included in the catalysts in amounts of 10 ppm to 500 ppm, typically from 60 ppm to 300 ppm.

Examples of such pyrimidine derivatives are uracil, barbituric acid, orotic acid, thymine, 2-aminopyrimidine, 6-hydroxy-2,4-dimethylpyrimidine, 6-methyluracil, 2-hydroxypyrimidine, 4,6-dichloropyrimidine, 2,4-dimethoxypyrimidine, 2-amino-4,6-dimethylpyrimidine, 2-hydroxy-4,6-dimethylpyrimidine and 6-methylisocytosine.

Sources of metal ions include any of the conventional water soluble metal salts known in the art and literature which provide metals having catalytic activity. One type of catalytic metal ion may be used or mixtures of two or more catalytic metal ions may be used. Such salts are included to provide metal ions in amounts of 20 ppm to 350 ppm, preferably from 25 ppm to 250 ppm. Silver salts include, but are not limited to silver nitrate, silver acetate, silver trifluoroacetate, silver tosylate, silver triflate, silver fluoride, silver oxide, silver sodium thiosulfate and silver potassium cyanide. Palladium salts include, but are not limited to palladium chloride, palladium acetate, palladium potassium chloride, palladium sodium chloride, sodium tetrachloropalladate and palladium nitrate. Gold salts include, but are not limited to gold cyanide, gold trichloride, gold tribromide, potassium gold chloride, potassium gold cyanide, sodium gold chloride and sodium gold cyanide. Platinum salts include, but are not limited to platinum chloride and platinum sulfate. Copper salts include, but are not limited to copper sulfate and copper chloride. Nickel salts include, but are not limited to nickel chloride and nickel sulfate. Cobalt salts include, but are not limited to cobalt acetate, cobalt chloride, cobalt bromide and cobalt ammonium sulfate. Preferably the metal ions are silver, palladium and gold ions. More preferably the metal ions are silver and palladium. Most preferably the ions are palladium.

The components which make up the aqueous alkaline catalysts may be combined in any order. Any suitable method known in the art and literature may be used to prepare the aqueous catalysts; however, no heating is applied to form an oligomer or polymer of the complexing pyrimidine derivative and the metal ions. The aqueous alkaline catalyst solution is substantially a solution of monomers of pyrimidine derivative complexing compound and metal ions. The amount of pyrimidine derivative complexing compounds and one or more metal ions included in the aqueous alkaline catalyst solutions are such that a molar ratio of complexing compounds to metal ions is from 1:1 to 4:1, preferably from 1:1 to 2:1. In general, one or more of the complexing compounds is first solubilized in a sufficient amount of water. One or more sources of metal ions are dissolved in a minimal amount of water and then combined with the complexing solution with stirring to form a uniform aqueous solution. Typically the catalyst solution is prepared at room temperature but some heating may be required to expedite solubilization of the components. The pH of the aqueous catalyst solution is adjusted to an alkaline pH with salts such as sodium tetraborate, sodium carbonate or alkali metal hydroxides such as potassium or sodium hydroxide or mixtures thereof. The pH range of the aqueous alkaline catalyst solution is from 8.5 and greater, preferably from 9 and greater, more preferably from 9 to 13, most preferably from 9 to 12. The aqueous alkaline catalysts are free of tin, tin ions and antioxidants. Preferably the aqueous alkaline catalysts are halogen free.

Following application of the catalyst to the substrate and prior to metallization one or more reducing agents are applied to the catalyzed substrate to reduce the metal ions to their metallic state. Conventional reducing agents known to reduce metal ions to metal may be used. Such reducing agents include, but are not limited to dimethylamine borane, sodium borohydride, ascorbic acid, iso-ascorbic acid, sodium hypophosphite, hydrazine hydrate, formic acid and formaldehyde. Preferably the reducing agent is sodium hypophosphite. Reducing agents are included in amounts to reduce substantially all of the metal ions to metal. Such amounts are generally conventional amounts and are well known by those of skill in the art.

The aqueous alkaline catalysts may be used to electrolessly metal plate various substrates such as semiconductors, metal-clad and unclad substrates such as printed circuit boards. Such metal-clad and unclad printed circuit boards may include thermosetting resins, thermoplastic resins and combinations thereof, including fiber, such as fiberglass, and impregnated embodiments of the foregoing. Preferably the substrate is a metal-clad printed circuit or wiring board.

Thermoplastic resins include, but are not limited to acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

The catalysts may be used to plate substrates with both low and high T_{g} resins. Low T_{g} resins have a T_{g} below 160° C and high T_{g} resins have a T_{g} of 160° C and above. Typically high T_{g} resins have a T_{g} of 160° C to 280° C or such as from 170° C to 240° C. High T_{g} polymer resins include, but are not limited to, polytetrafluoroethylene (PTFE) and polytetrafluoroethylene blends. Such blends include, for example, PTFE with polypheneylene oxides and cyanate esters. Other classes of polymer resins which include resins with a high Tg include, but are not limited to, epoxy resins, such as difunctional and multifunctional epoxy resins, bimaleimide/triazine and epoxy resins (BT epoxy), epoxy/polyphenylene oxide resins, acrylonitrile butadienestyrene, polycarbonates (PC), polyphenylene oxides (PPO), polyphenylene ethers (PPE), polyphenylene sulfides (PPS), polysulfones (PS), polyamides, polyesters such as polyethyleneterephthalate (PET) and polybutyleneterephthalate (PBT), polyetherketones (PEEK), liquid crystal polymers, polyurethanes, polyetherimides, epoxies and composites thereof.

The catalysts may be used to deposit metals on dielectric materials and the walls of through-holes or vias of printed circuit boards. The catalysts may be used in both horizontal and vertical processes of manufacturing printed circuit boards.

The aqueous catalysts may be used with conventional alkaline electroless metal plating baths. While it is envisioned that the catalysts may be used to electrolessly deposit any metal which may be electrolessly plated, preferably, the metal is chosen from copper, copper alloys, nickel or nickel alloys. More preferably the metal is chosen from copper and copper alloys, most preferably copper is the metal. An example of a commercially available electroless copper plating bath is CIRCUPOSIT™ 880 Electroless Copper bath (available from Dow Advanced Materials, Marlborough, MA).

Typically sources of copper ions include, but are not limited to water soluble halides, nitrates, acetates, sulfates and other organic and inorganic salts of copper. Mixtures of one or more of such copper salts may be used to provide copper ions. Examples include copper sulfate, such as copper sulfate pentahydrate, copper chloride, copper nitrate, copper hydroxide and copper sulfamate. Conventional amounts of copper salts may be used in the compositions. In general copper ion concentrations in the composition may range from 0.5 g/L to 30 g/L.

One or more alloying metals also may be included in the electroless compositions. Such alloying metals include, but are not limited to nickel and tin. Examples of copper alloys include copper/nickel and copper/tin. Typically the copper alloy is copper/nickel.

Sources of nickel ions for nickel and nickel alloy electroless baths may include one or more conventional water soluble salts of nickel. Sources of nickel ions include, but are not limited to, nickel sulfates and nickel halides. Sources of nickel ions may be included in the electroless alloying compositions in conventional amounts. Typically sources of nickel ions are included in amounts of 0.5 g/L to 10 g/L.

Conventional steps used for electrolessly metal plating a substrate may be used with the catalysts; however, the aqueous alkaline catalysts do not require an acceleration step where tin is stripped to expose the palladium metal for electroless plating as in many conventional processes. Accordingly, acceleration steps are excluded when using the catalysts. Preferably, the catalysts are applied to the surface of the substrate to be electrolessly plated with a metal followed by application of a reducing agent to the catalyzed substrate and then application of the metal plating bath. Electroless metal plating parameters, such as temperature and time may be conventional. The pH of the electroless metal plating bath is alkaline. Conventional substrate preparation methods, such as cleaning or degreasing the substrate surface, roughening or micro-roughening the surface, etching or micro-etching the surface, solvent swell applications, desmearing through-holes and various rinse and anti-tarnish treatments may be used. Such methods and formulations are well known in the art and disclosed in the literature.

Preferably, the substrate to be metal plated is a metal-clad substrate with dielectric material and a plurality of through-holes such as a printed circuit board. The boards are rinsed with water and cleaned and degreased followed by desmearing the through-hole walls. Typically prepping or softening the dielectric or desmearing of the through-holes begins with application of a solvent swell.

Any conventional solvent swell may be used. The specific type may vary depending on the type of dielectric material. Examples of dielectrics are disclosed above. Minor experimentation may be done to determine which solvent swell is suitable for a particular dielectric material. The T_{g} of the dielectric often determines the type of solvent swell to be used. Solvent swells include, but are not limited to glycol ethers and their associated ether acetates. Conventional amounts of glycol ethers and their associated ether acetates may be used. Examples of commercially available solvent swells are CIRCUPOSIT™ Conditioner 3302A, CIRCUPOSIT™ Hole Prep 3303 and CIRCUPOSIT™ Hole Prep 4120 solutions (available from Dow Advanced Materials).

After the solvent swell, a promoter may be applied. Conventional promoters may be used. Such promoters include sulfuric acid, chromic acid, alkaline permanganate or plasma etching. Typically alkaline permanganate is used as the promoter. Examples of commercially available promoters are CIRCUPOSIT™ Promoter 4130 and CIRCUPOSIT™ MLB Promoter 3308 solutions (available from Dow Advanced Materials). Optionally, the substrate and through-holes are rinsed with water.

A neutralizer is then applied to neutralize any residues left by the promoter. Conventional neutralizers may be used. Typically the neutralizer is an aqueous acidic solution containing one or more amines or a solution of 3wt% hydrogen peroxide and 3wt% sulfuric acid. An example of a commercially available neutralizer is CIRCUPOSIT™ MLB Neutralizer 216-5. Optionally, the substrate and through-holes are rinsed with water and then dried.

After neutralizing an acid or alkaline conditioner is applied. Conventional conditioners may be used. Such conditioners may include one or more cationic surfactants, non-ionic surfactants, complexing agents and pH adjusters or buffers. Examples of commercially available acid conditioners are CIRCUPOSIT™ Conditioners 3320A and 3327 solutions (available from Dow Advanced Materials). Suitable alkaline conditioners include, but are not limited to aqueous alkaline surfactant solutions containing one or more quaternary amines and polyamines. Examples of commercially available alkaline surfactants are CIRCUPOSIT™ Conditioner 231, 3325, 813 and 860 formulations. Optionally, the substrate and through-holes are rinsed with water.

Conditioning may be followed by micro-etching. Conventional micro-etching compositions may be used. Micro-etching is designed to provide a micro-roughened metal surface on exposed metal (e.g. innerlayers and surface etch) to enhance subsequent adhesion of plated electroless metal and later electroplate. Micro-etches include, but are not limited to 60 g/L to 120 g/L sodium persulfate or sodium or potassium oxymonopersulfate and sulfuric acid (2%) mixture, or generic sulfuric acid/hydrogen peroxide. Examples of commercially available micro-etching compositions are CIRCUPOSIT™ Microetch 3330 Etch solution and PREPOSIT™ 748 Etch solution both available from Dow Advanced Materials. Optionally, the substrate is rinsed with water.

Optionally, a pre-dip may then applied to the micro-etched substrate and through-holes. Examples of pre-dips include organic salts such as sodium potassium tartrate or sodium citrate, 0.5% to 3% sulfuric acid or an acidic solution of 25 g/L to 75 g/L sodium chloride.

The aqueous alkaline catalyst is then applied to the substrate. Application may be done by conventional methods used in the art, such as immersing the substrate in a solution of the catalyst or by spraying or by atomization using conventional apparatus. Catalyst dwell time may range from 1 minute to 10 minutes, typically from 2 minutes to 8 minutes for vertical equipment and for 25 seconds to 120 seconds for horizontal equipment. The catalysts may be applied at temperatures from room temperature to 80° C, typically from 30° C to 60° C. The substrate and through-holes optionally may be rinsed with water after application of the catalyst.

The reducing solution is then applied to the substrate to reduce the metal ions of the catalyst to their metallic state. The reducing solution may be applied by immersing the substrate into the reducing solution, spraying the reducing solution onto the substrate or by applying the solution by atomization. The temperature of the solution may range from room temperature to 65° C, typically from 30° C to 55° C. Contact time between the reducing solution and the catalyzed substrate may range from 30 seconds to 5 minutes before application of the electroless metal plating bath. Typically the reducing solution is 6 and higher.

The substrate and walls of the through-holes are then electrolessly plated with metal, such as copper, copper alloy, nickel or nickel alloy using an electroless bath. Preferably copper is plated on the walls of the through-holes. Plating times and temperatures may be conventional. Typically metal deposition is done at temperatures of 20° C to 80°, more typically from 30° C to 60° C. The substrate may be immersed in the electroless plating bath or the electroless bath may be sprayed onto the substrate. Typically, electroless plating may be done for 5 seconds to 30 minutes; however, plating times may vary depending on the thickness of the metal desired. Plating is done in an alkaline environment to prevent undesired corrosion of any metal cladding on the substrate. Typically the pH of the plating solution is 8 and higher, preferably the pH is 8.5 and greater, more preferably the pH is from 9 to 13.

Optionally anti-tarnish may be applied to the metal. Conventional anti-tarnish compositions may be used. An example of anti-tarnish is ANTI TARNISH™ 7130 solution (available from Dow Advanced Materials). The substrate may optionally be rinsed with water and then the boards may be dried.

Further processing may include conventional processing by photoimaging and further metal deposition on the substrates such as electrolytic metal deposition of, for example, copper, copper alloys, tin and tin alloys.

The aqueous alkaline catalysts may be used to electrolessly plate metals on substrates of dielectric materials and substrates which also include metal cladding. The aqueous alkaline catalysts are storage stable and are stable during electroless metal plating even in alkaline electroless metal plating environments. They do not readily oxidize as compared to conventional tin/palladium catalysts even though the aqueous alkaline catalysts are free of antioxidants. They do not require strong acids to prepare or maintain stability, thus they are less corrosive than conventional catalysts. They do not require tin compounds for stability and may be halogen free. Also, oligomeric/polymeric complex formation with prolonged heating is not required to form stable and catalytically active metal ligand complexes providing a more efficient electroless plating method. The catalysts enable good metal coverage during via and through-hole filling in the manufacture of printed circuit boards.

The following examples are not intended to limit the scope of the invention but to further illustrate the invention.

### Example 1

An aqueous alkaline catalyst solution containing 75 ppm palladium ions and 85 ppm 6-hydroxy-2,4-dimethylpyrimide (HDMP) in one liter of water was prepared by diluting a 17 mL aliquot of a 5 g/L HDMP stock solution with 400 mL of DI water. The pH of the solution was adjusted to 10.5 with 1 M sodium hydroxide. 188 mg of palladium nitrate hydrate was dissolved in a minimum of DI water and added to the HDMP solution. 1.9 g of sodium tetraborate decahydrate was dissolved in a one liter beaker containing 400 mL of DI water and the palladium nitrate and HDMP solution was added to it. The mixture was then diluted to one liter and stirred 30 minutes at room temperature. The molar ratio of HDMP to palladium ions was 1:1. The pH of the solution was 9.

### Example 2

Two each of six different panels with a plurality of through-holes were provided: TUC-662, SY-1141, SY-1000-2, IT-158, IT-180 and NPG-150. The panels were either four-layer or eight-layer copper-clad panels. TUC-662 was obtained from Taiwan Union Technology, and SY-1141 and SY-1000-2 were obtained from Shengyi. IT-158 and IT-180 were obtained from ITEQ Corp. and NPG-150 was obtained from NanYa. The T_{g} values of the panels ranged from 140° C to 180° C. Each panel was 5cm x 12cm. The through-holes of each panel were treated as follows:
1. The through-holes of each panel were desmeared with CIRCUPOSIT™ MLB Conditioner 211 solution for 7 minutes at 80° C;
2. The through-holes of each panel were then rinsed with flowing tap water for 4 minutes;
3. The through-holes were then treated with CIRCUPOSIT™ MLB Promoter 3308 aqueous permanganate solution at 80° C for 10 minutes;
4. The through-holes were then rinsed for 4 minutes in flowing tap water;
5. The through-holes were then treated with a 3wt% sulfuric acid/3wt% hydrogen peroxide neutralizer at room temperature for 2 minutes;
6. The through-holes of each panel were then rinsed with flowing tap water for 4 minutes;
7. The through-holes of each panel were then treated with CIRCUPOSIT™ Conditioner 3325 alkaline solution for 5 minutes at 60° C;
8. The through-holes were then rinsed with flowing tap water for 4 minutes;
9. The through-holes were then treated with a sodium persulfate/sulfuric acid etch solution for 2 minutes at room temperature;
10. The through-holes of each panel were then rinsed with flowing DI water for 4 minutes;
11. Half of the panels were then immersed in CATAPREP™ 404 Pre-Dip solution at room temperature for 1 minute followed by immersing the panels in a solution of a conventional palladium/tin catalyst having 75 ppm of palladium metal with an excess of tin for 5 minutes at 40° C; while the other half of the panels were immersed in the palladium ions/HDMP catalyst prepared in Example 1 for 5 minutes at 40° C;
12. The panels which were treated with the catalyst containing palladium ions and HDMP were then immersed in a 0.25M solution of sodium hypophosphite reducing agent at 50° C for 1 minute to reduce the palladium ions to palladium metal and then rinsed with flowing DI water for 30 seconds;
13. The panels were then immersed in CIRCUPOSIT™ 880 Electroless Copper plating bath at 38° C and at a pH of 13 and copper was deposited on the walls of the through-holes for 15 minutes;
14. The copper plated panels were then rinsed with flowing tap water for 4 minutes;
15. Each copper plated panel was then dried with compressed air; and
16. The walls of the through-holes of the panels were examined for copper plating coverage using the backlight process described below.

Each panel was cross-sectioned nearest to the centers of the through-holes as possible to expose the copper plated walls. The cross-sections, no more than 3 mm thick from the center of the through-holes, were taken from each panel to determine the through-hole wall coverage. The European Backlight Grading Scale was used. The cross-sections from each panel were placed under a conventional optical microscope of 50X magnification with a light source behind the samples. The quality of the copper deposits was determined by the amount of light visible under the microscope that was transmitted through the sample. Transmitted light was only visible in areas of the plated through-holes where there was incomplete electroless coverage. If no light was transmitted and the section appeared completely black, it was rated a 5 on the backlight scale indicating complete copper coverage of the through-hole wall. If light passed through the entire section without any dark areas, this indicated that there was very little to no copper metal deposition on the walls and the section was rated 0. If sections had some dark regions as well as light regions, they were rated between 0 and 5. A minimum of ten through-holes were inspected and rated for each board.

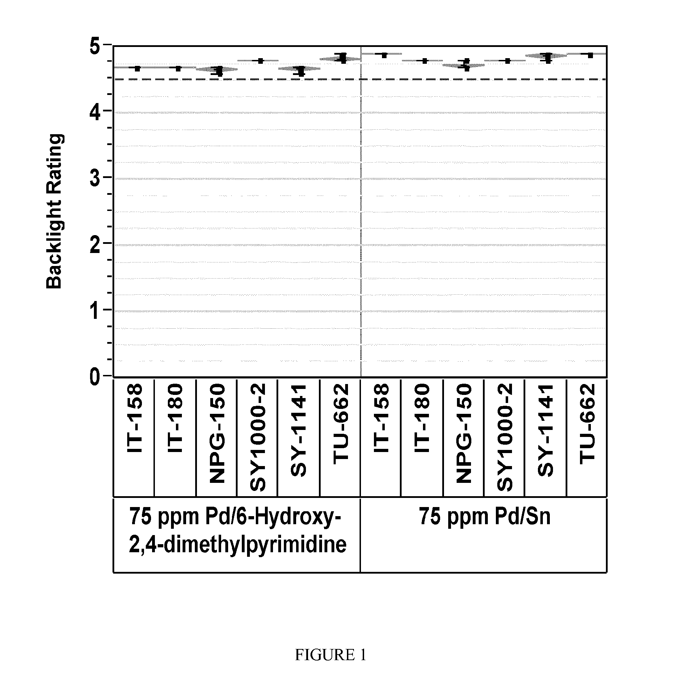

Figure 1 is a backlight rating distribution graph showing the backlight performance of both catalysts for each of the six types of panels plated. The plots in the graph indicate a 95% confidence interval for the backlight ratings of ten through-holes sectioned for each board. The horizontal line through the middle of each plot indicates the average backlight value for each group of ten through-hole sections measured. The palladium/HDMP catalyst performed substantially the same as the conventional palladium/tin colloidal catalyst with backlight values of greater than 4.5. Backlight values of 4.5 and greater are indicative of commercially acceptable catalysts in the plating industry.

### Example 3

An aqueous alkaline catalyst solution containing 75 ppm palladium ions and 105 ppm 2-amino-4,6-dimethylpyrimide (ADMP) in one liter of water was prepared by diluting a 21 mL aliquot of a 5 g/L ADMP stock solution with 400 mL of DI water. 188 mg of palladium nitrate hydrate was dissolved in a minimum of DI water and added to the ADMP solution. The pH of the solution was adjusted to 8.5 with 1M sodium hydroxide. 1.9 g of sodium tetraborate decahydrate was dissolved in a one liter beaker containing 400 mL of DI water and the palladium nitrate and ADMP solution was added to it. The mixture was then diluted to one liter and stirred 30 minutes at room temperature. The molar ratio of ADMP to palladium ions was 1.2:1. The pH of the solution was 9.

### Example 4

Two each of six different multi-layer, copper-clad panels with a plurality of through-holes were provided as in Example 2: TUC-662, SY-1141, SY-1000-2, IT-158, IT-180 andNPG-150. The through-holes of each panel were treated as follows:
1. The through-holes of each panel were desmeared with CIRCUPOSIT™ MLB Conditioner 211 solution for 7 minutes at 80° C;
2. The through-holes of each panel were then rinsed with flowing tap water for 4 minutes;
3. The through-holes were then treated with CIRCUPOSIT™ MLB Promoter 3308 aqueous permanganate solution at 80° C for 10 minutes;
4. The through-holes were then rinsed for 4 minutes in flowing tap water;
5. The through-holes were then treated with a 3wt% sulfuric acid/3wt% hydrogen peroxide neutralizer at room temperature for 2 minutes;
6. The through-holes of each panel were then rinsed with flowing tap water for 4 minutes;
7. The through-holes of each panel were then treated with CIRCUPOSIT™ Conditioner 3320A alkaline solution for 5 minutes at 45° C;
8. The through-holes were then rinsed with flowing tap water for 4 minutes;
9. The through-holes were then treated with sodium persulfate/sulfuric acid etch solution for 2 minutes at room temperature;
10. The through-holes of each panel were then rinsed with flowing DI water for 4 minutes;
11. Half of the panels were then immersed in CATAPREP™ 404 Pre-Dip solution at room temperature for 1 minute followed by immersing the panels in a solution of a conventional palladium/tin catalyst having 75 ppm of palladium metal with an excess of tin for 5 minutes at 40° C; while the other half of the panels were immersed in the palladium ions/AMDP catalyst prepared in Example 3 for 5 minutes at 40° C;
12. The panels which were treated with the catalyst containing palladium ions and AMDP were then immersed in a 0.25M solution of sodium hypophosphite reducing agent at 50° C for 1 minute to reduce the palladium ions to palladium metal and then rinsed with flowing DI water for 30 seconds;
13. The panels were then immersed in CIRCUPOSIT™ 880 Electroless Copper plating bath at 38° C and at a pH of 13 and copper was deposited on the walls of the through-holes for 15 minutes;
14. The copper plated panels were then rinsed with flowing tap water for 4 minutes;
15. Each copper plated panel was then dried with compressed air; and
16. The walls of the through-holes of the panels were examined for copper plating coverage using the backlight process described below.

Each panel was cross-sectioned nearest to the centers of the through-holes as possible to expose the copper plated walls. The cross-sections, no more than 3 mm thick from the center of the through-holes, were taken from each panel to determine the through-hole wall coverage. The European Backlight Grading Scale was used as described in Example 2.

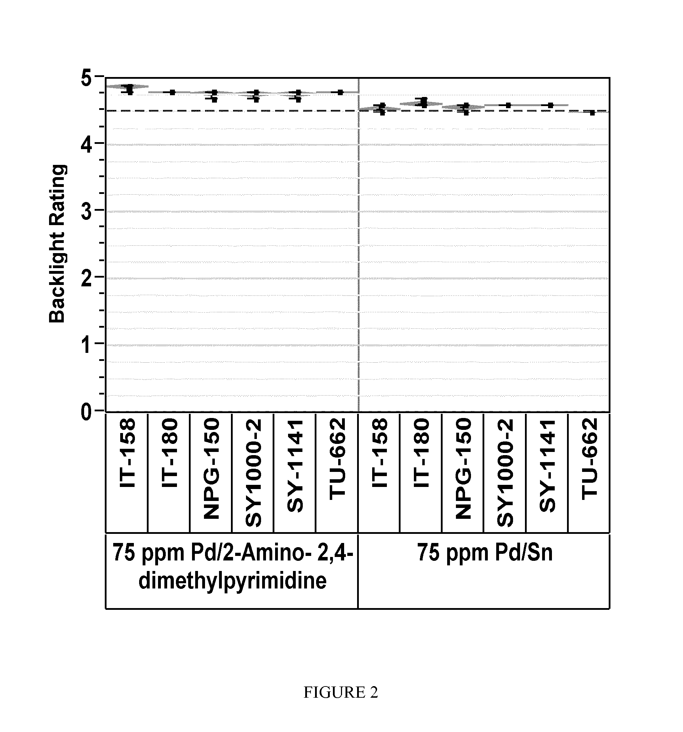

Figure 2 is a backlight rating distribution graph showing the backlight performance of both catalysts for each of the six types of panels plated. The plots in the graph indicate a 95% confidence interval for the backlight ratings of ten through-holes sectioned for each board. The horizontal line through the middle of each plot indicates the average backlight value for each group of ten through-hole sections measured. The palladium/ADMP catalyst performed better than the conventional palladium/tin colloidal catalyst with backlight values of greater than 4.5 while the backlight values of the conventional catalyst were 4.5 or just slightly above 4.5.

### Examples 5-17

The pyrimidine derivatives listed in the table below were tested for catalyst stability and activity on a 40 mL scale. All of the catalysts were prepared with 75 ppm palladium ions and 1.9 g/L sodium tetraborate decahydrate as a pH buffer to maintain a pH of around 9. With the exception of Examples 9, 13 and 14, two samples of each complexing agent were tested at different amounts. The molar ratio of palladium ions to complexing agent were either 1:1 or 1:2. The molar ratio of palladium ions to complexing agent in Examples 9, 13 and 14 were 1:1.

### Stock solutions:

a) Complexing agent solutions were 5 g/L;
b) Palladium ion solution of 5 g/L was prepared from palladium nitrate hydrate; and
c) Sodium tetraborate decahydrate solution was 25 g/L.
Working bath formulations and method:
1. A aliquot of the complexing agent was diluted in 30 mL DI water;
2. pH of complexing agent solution was adjusted to around 10.5 with 1M sodium hydroxide for Examples 5-8, 10-14 and 16-17;
3. 0.6 mL palladium ion solution was added, the catalysts were stirred for 5 minutes at room temperature and 1M sodium hydroxide was added to the 2-aminopyrimidine based complexing agents of Examples 9 and 15 to adjust the pH to around 8.5; and
4. 3.05 mL of borate solution was added and the catalyst was diluted to 40 mL to adjust the pH to around 9.
5. Screen plating activity on small scale (beaker) tests using un-clad, laminate NY-1140 samples from NanYa was done according to the following process:
a) 10% CIRCUPOSIT™ Conditioner 3325 alkaline solution was applied to the laminates in Examples 5-8, 10-14 and 16-17 and 7% CIRCUPOSIT™ Conditioner 3320A acid solution was applied to the laminates of Examples 9 and 15 for 5 minutes at 50 °C then rinsed with DI water;
b) Catalyst baths were applied to the laminates for 5 minutes at 40 °C;
c) 0.25 M NaH₂PO₂ reducing agent was applied to the laminates for 1 minute at 50 °C followed by DI water rinse;
d) Laminates were plated with copper using CIRCUPOSIT™ 880 Electroless Copper plating bath for 15 minutes at 40 °C followed by rinsing with DI water then dried at room temperature; and
e) The laminates were examined for copper plating performance. The results are shown in Table 1.

**Table 1**

| **Example** | **Complexing Agent** | **Stability** | **Concentration (ppm)** | **Copper Coverage** |
|---|---|---|---|---|
| **5** | Uracil | yes | 80 and 160 | Full coverage |
| **6** | Barbituric acid | yes | 90 and 180 | Full coverage |
| **7** | Orotic acid | Partially stable: cloudy overnight | 120 and 240 | Full coverage |
| **8** | Thymine | Yes | 90 and 180 | Full coverage |
| **9** | 2-aminopyrimidine | Small amount of precipitate observed after one week at room temperature and exposed to air | 80 | Full coverage |
| **10** | 6-hydroxy-2,4-dimethylpyrimidine | yes | 85 and 170 | Full coverage |
| **11** | 6-methyluracil | yes | 90 and 180 | Full coverage |
| **12** | 2-hydroxypyrimidine hydrochloride salt | yes | 67 and 134 | Full coverage |
| **13** | 4,6-dichloropyrimidine | yes | 105 | 75% coverage due to skip plating |
| **14** | 2,4-dimethoxpyrimidine | yes | 198 | Full coverage |
| **15** | 2-amino-4,6-dimethylpyrimidine | yes | 87 and 174 | Full coverage |
| **16** | 2-hydroxy-4,6-dimethylpyrimidine | yes | 88 and 175 | Full coverage |
| **17** | 6-methylisocytosine | yes | 88 and 175 | Full coverage |

All of the laminates had bright copper deposits with full uniform coverage with the exception of Example 13 where the complexing agent was 4,6-dichloropyrimidine; however, the section of the laminate which was covered was bright.

In addition to the appearance of the copper deposits, the stability of the complexing agent solutions were also observed over a 2-4 hour period at 40° C during preparation of the laminates and copper plating and then overnight after plating when the solutions were cooled to room temperature. Most of the test samples were stable during heating and overnight. With the exceptions of Examples 7 and 9, no precipitation or cloudiness was observed. Nevertheless, both orotic acid and 2-aminopyrimidine provided full copper coverage on the laminates.

### Comparative Examples 1-4

The stability tests and electroless copper plating on laminate NY-1140 samples were repeated except that the complexing agents used were those in Table 2 below. The pyrimidine derivatives had hydroxyl substitutions in the 4 and 6 positions of the pyrimidine ring without a substitution at the 2 position, or hydroxyl substitutions at the 4 and 6 positions and an amine group at the number 2 position, or amine substitutions at positions 2, 4 and 6 of the pyrimidine ring. The solutions were prepared in the same way as described in Examples 5-17.

**Table 2**

| **Comparative Example** | **Complexing Agent** | **Stability** | **Concentration (ppm)** | **Copper Coverage** |
|---|---|---|---|---|
| **1** | 2-amino-4,6-dihydroxypyrimidine | yes | 90 and 180 | no |
| **2** | 2,4,6-triaminopyrimidine | no | 45, 88 and 175 | ------ |
| **3** | 4-methylpyrimidine | no | 65 and 130 | ------ |
| **4** | 4,6-dihydroxypyrimidine | yes | 80 and 160 | no |

Although the catalysts of Comparative Examples 1 and 4 were stable, they failed to catalyze electroless copper plating on the laminates. The catalysts of Comparative Examples 2 and 3 were unstable. Precipitation was observed within minutes of mixing the complexing agent and palladium nitrate hydrate.

## Claims

1. A method comprising:
a) providing a substrate comprising a dielectric;
b) applying an aqueous alkaline catalyst solution to the substrate comprising the dielectric, the aqueous alkaline catalyst comprises a monomeric complex of metal ions and one or more pyrimidine derivatives having formula: 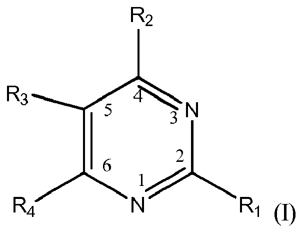 wherein R₁, R₂, R₃ and R₄ may be the same or different and are hydrogen, (C₁-C₃)alky, -N(R)₂, hydroxyl, hydroxy(C₁-C₃)alkyl, (C₁-C₃)alkoxy, carboxy or halogen, and where R may be the same or different and is hydrogen or (C₁-C₃)alkyl, and with the proviso that when R₂ and R₄ are hydroxyl, R₁ is also hydroxyl, R₁, R₂ and R₄ cannot be -N(R)₂ at the same instance and when R₂ is an alkyl, R₁, R₃ and R₄ cannot all be hydrogen, and R₁, R₂, R₃ and R₄ are not hydrogen at the same instance; or salts thereof;
c) applying a reducing agent to the substrate comprising the dielectric; and
d) immersing the substrate comprising the dielectric into an alkaline metal plating bath to electrolessly plate metal on the substrate comprising the dielectric.

2. The method of claim 1, wherein the one or more pyrimidine derivatives are chosen from uracil, barbituric acid, orotic acid, thymine, 2-aminopyrimidine, 6-hydroxy-2,4,6-triaminopyrimidine, 6-methyluracil, 2-hydroxypyrimidine, 4,6-dichloropyrimidine, 2,4-dimethoxypyrimidine, 2-amino-4,6-dimethylpyrimidine, 2-hydroxy-4,6-dimethylpyrimidine and 6-methylisocytosine.

3. The method of claim 1, wherein a molar ratio of the one or more pyrimidine derivatives to the metal ions is 1:1 to 4:1.

4. The method of claim 1, wherein the metal ions are chosen from palladium, silver, gold, platinum, copper, nickel and cobalt.

5. The method of claim 1, wherein the metal on the substrate is copper, copper alloy, nickel or nickel alloy.

6. The method of claim 1, wherein the aqueous alkaline catalyst solution has a pH of 8.5 or greater.

7. The method of claim 6, wherein the aqueous alkaline catalyst solution has pH of 9 or greater.

8. The method of claim 1, wherein the substrate comprising the dielectric further comprises a plurality of through-holes.

9. The method of claim 8, wherein the substrate comprising the dielectric further comprises metal cladding.
